# FASCICULE DE BREVET EUROPEEN

(11) **EP 2 694 879 B1**
(45) Date de publication et mention de la délivrance du brevet: **24.08.2016**
(21) Numéro de dépôt: 12714664.5
(22) Date de dépôt: 05.04.2012
(51) Int. Cl.: F23D 14/18, F23D 99/00, F24J 2/07, H01L 31/042

(54) **SYSTEME THERMOPHOTOVOLTAÏQUE COMPORTANT UN EMETTEUR**
THERMOVOLTAISCHES SYSTEM UMFASSEND EINEN EMITTER
THERMOPHOTOVOLTAIC SYSTEM COMPRISING AN EMITTER

(30) Priorité: 06.04.2011 FR 1153000
(43) Date de publication de la demande: 12.02.2014
(73) Titulaire: Commissariat à l'Énergie Atomique et aux Énergies Alternatives, 75015 Paris (FR)
(72) Inventeur: OLLIER, Emmanuel, F-38000 Grenoble (FR)
(74) Mandataire: Ahner, Philippe
(86) Numéro de dépôt international: PCT/EP2012/056345
(87) Numéro de publication internationale: WO 2012/136800

(56) Documents cités:
- WO-A1-00/49339
- US-A- 932 029
- US-A- 5 356 487
- US-A- 6 092 912
- US-B1- 6 372 979

## Description

### DOMAINE TECHNIQUE ET ART ANTÉRIEUR

La présente invention se rapporte à un émetteur pour système thermophotovoltaïque et à un système thermophotovoltaïque comportant au moins un tel émetteur, ledit système étant par exemple destiné à la production d'électricité par conversion de chaleur ou au chauffage d'éléments.

Il existe des systèmes comportant des cellules photovoltaïques convertissant le rayonnement solaire en électricité. Cependant des systèmes ne fonctionnent que le jour, i.e. en présence du rayonnement solaire.

Ces systèmes comportent des cellules photovoltaïques de structure complexes permettant une utilisation optimisée du spectre solaire, le rayonnement solaire utilisé est préalablement concentré au moyen d'un concentrateur. Cependant le rendement de tels systèmes chute lorsque les conditions de rayonnement ne sont plus spéculaires (i.e. le rayonnement est diffus) par exemple du fait de la pollution ou d'une couverture nuageuse, et lorsque les conditions climatiques s'écartent des conditions idéales pour lesquelles les systèmes ont été conçus. Il s'ensuit que la production annuelle peut être très aléatoire et que la mise en oeuvre de ces systèmes est en général limitée aux zones géographiques présentant un ensoleillement important et relativement homogène au cours de l'année.

Il existe des systèmes mixtes qui associent les cellules photovoltaïques pour convertir le rayonnement solaire visible et d'autres moyens pour convertir la chaleur produite par le rayonnement solaire infrarouge, cependant ces systèmes sont complexes et se contentent de juxtaposer les systèmes, ce qui rend leur coût élevé.

En outre, puisque les systèmes à cellules photovoltaïques offrent un rendement limité du fait de leur fonctionnement limité au jour, l'amortissement de tels systèmes est long.

Il existe également des systèmes utilisant des cellules thermophotovoltaïques convertissant un rayonnement électromagnétique émettant dans l'infrarouge en électricité. En d'autres termes, elles convertissent la chaleur en électricité.

Le document US 7 557 293 décrit un système thermophotovoltaïque comportant une chambre de combustion alimentée en air et en carburant, entourée d'un émetteur, lui-même entouré de cellules thermophotovoltaïques. La chaleur dégagée par la combustion est alors transmise à l'émetteur qui émet un rayonnement infrarouge aux cellules qui convertissent cette chaleur en électricité. Ce système n'utilise pas le rayonnement solaire.

Le document CA 2 085 752 décrit un système de génération de courant comportant des cellules thermophotovoltaïques sensibles à un rayonnement infrarouge. Dans l'une des solutions proposées, le chauffage peut être effectué soit par un rayonnement lumineux concentré, soit par la combustion d'un gaz. Le système comporte une cavité cylindrique dans laquelle a lieu la concentration, la chambre de combustion est formée par la cavité cylindrique, les cellules thermophotovoltaïques sont disposées autour de la cavité cylindrique. La surface chauffée par le rayonnement solaire ou par la combustion sont identiques. L'émission infrarouge se fait par excitation d'une vapeur de césium contenue dans une cavité en tungstène entourant la cavité cylindrique ce qui provoque l'émission de rayonnement infrarouge, le tungstène ayant pour fonction d'émettre des électrons d'excitation du césium lorsqu'il est porté à très haute température. Cette température est très élevée puisqu'elle est de l'ordre 1800°C, Les contraintes thermomécaniques appliquées à ce système sont donc fortes et la fiabilité de ce système peut être un problème. Nécessairement le système doit être en tungstène pour tenir à une telle température. En outre, un fonctionnement sous vide est nécessaire pour ne pas dégrader le tungstène à l'air. Le système est donc complexe. En outre, le système est relativement encombrant. Enfin, la complexité liée au vide, à la cavité de césium et à la taille des éléments rend la juxtaposition de plusieurs modules difficile sur un même système de suivi du soleil.

Le document US 63 72 979 B1 décrit un système thermophotovoltaïque qui comprend une chambre de combustion catalytique.

### EXPOSÉ DE L'INVENTION

C'est par conséquent un but de la présente invention d'offrir un système capable de générer de l'électricité sur une grande plage de temps, voire en permanence, quelles que soient les conditions d'illumination, tout en offrant une structure relativement simple et fiable par rapport aux systèmes existants.

Le but précédemment énoncé est atteint par un système mettant en oeuvre des cellules thermophotovoltaïques destinées à transformer un rayonnement infrarouge en électricité, le rayonnement infrarouge provenant d'un émetteur comportant une surface extérieure recevant un rayonnement solaire, au moins une chambre de combustion et une surface extérieure émettant un rayonnement infrarouge. Ainsi le système peut fonctionner en permanence soit du fait du rayonnement lumineux, soit de la combustion opérée dans la chambre de combustion, soit du fait de la combinaison du rayonnement lumineux et de la combustion.

En utilisant un émetteur qui combine à la fois le rôle de chambre de combustion et de surface réceptrice du rayonnement solaire, le système est simplifié. En outre, le chauffage de l'émetteur peut être obtenu soit grâce au rayonnement solaire uniquement, soit uniquement par la combustion, soit par une combinaison des deux.

En d'autres termes, l'invention met en oeuvre un émetteur hybride émettant un rayonnement infrarouge à partir d'un rayonnement lumineux et/ou d'une chaleur d'origine chimique émise lors de la combustion. Cet émetteur comporte trois types de surfaces :
- une surface externe dédiée à la réception du flux solaire concentré,
- une surface interne dédiée au chauffage par combustion,
- une surface externe d'émission du rayonnement infrarouge, les cellules thermophotovoltaïques de conversion du rayonnement infrarouge en électricité étant alors situées en face des surfaces d'émission infrarouge.

De manière préférentielle, la surface recevant le rayonnement solaire concentré est opposée à celle émettant le rayonnement infrarouge, ce qui a pour résultat de protéger les cellules thermophotovoltaïques du rayonnement solaire concentré.

La chambre de combustion peut être formée par des canaux réalisés dans un corps plein ou par les pores d'un matériau réfractaire poreux.

De manière avantageuse, l'alimentation de la chambre se fait à travers une surface distincte des surfaces dédiée à la réception et l'émission.

L'alimentation et l'évacuation de la chambre de combustion ont lieu avantageusement au niveau des extrémités latérales par rapport à la direction du rayonnement solaire, laissant les faces extérieures de plus grandes surfaces disponibles pour recevoir le rayonnement lumineux et pour émettre le rayonnement infrarouge.

La présente invention a alors pour objet un système thermophotovoltaïque selon la revendication 1.

De manière préférée, la deuxième surface extérieure est opposée à la première surface extérieure par rapport à ladite au moins une chambre de combustion.

Dans un mode de réalisation, le corps comporte au moins un canal formant la chambre de combustion. Ledit au moins un canal s'étend préférentiellement sensiblement parallèle aux première et deuxième surfaces extérieures.

Dans un autre mode de réalisation, le corps de l'émetteur comporte une âme en matériau poreux (formant la chambre de combustion et une enveloppe en matériau non poreux.

Avantageusement, le ou les matériaux du corps de l'émetteur présentent une bonne conductivité thermique, de préférence supérieure à 100 W.m⁻¹.K⁻¹.

Le rapport entre la deuxième surface extérieure et la première surface extérieure est par exemple compris entre 1 et 10, avantageusement entre 1,5 et 4.

Dans un exemple de réalisation, le corps présente une forme de parallélépipède rectangle, une grande face portant la première surface extérieure et la deuxième grande face portant la deuxième surface extérieure, et dans lequel la chambre de combustion s'étend parallèlement aux première et deuxième surfaces extérieures.

Dans un autre exemple de réalisation, le corps présente une section en demi-cercle, et a la forme d'un demi-cylindre, la surface convexe formant la deuxième surface extérieure et la surface plane formant la première surface extérieure, la chambre de combustion s'étendant parallèlement aux première et deuxième surfaces extérieures.

Préférentiellement, la chambre de combustion est apte à être connectée à une source de carburant et d'oxygène au niveau d'au moins une de ses extrémités latérales par rapport aux première et deuxième surfaces extérieures.

La chambre de combustion peut avantageusement comporter un réseau de canaux de sorte à améliorer l'échange thermique entre les gaz de combustion et le corps de l'émetteur.

Selon une caractéristique additionnelle, la première surface extérieure peut comporter un dépôt d'un matériau et/ou présente une texturation apte à améliorer l'absorption du rayonnement solaire et à diminuer son émissivité en rayonnement infrarouge.

Selon une autre caractéristique additionnelle la deuxième surface extérieure peut comporter un dépôt d'un matériau et/ou une texturation apte à contrôler l'émission infrarouge en augmentant son intensité et en diminuant son émissivité aux hautes longueurs d'onde, par exemple supérieures à 1,7 µm.

La chambre de combustion peut comporter au moins un catalyseur de combustion.

Par exemple, le corps de l'émetteur est formé d'un ou plusieurs matériaux réfractaires tels que le carbure de silicium, tungstène, et/ou les oxydes de terres rares, tels que le Er₂O₃, Yb₂O₃.

Le système peut comporter des moyens de contrôle de la combustion en fonction du niveau de rayonnement solaire. De préférence, les moyens de contrôle commandent la combustion de sorte à maintenir l'émetteur à une température sensiblement constante.

Le système peut comporter une source de carburants tels que des composés carbohydrogénés, du dihydrogène ou des biogaz.

Le système peut également comporter des moyens pour évacuer la chaleur de la cellule thermophotovoltaïque.

Dans un exemple de réalisation, le concentrateur, l'émetteur et la cellule thermophotovoltaïque sont montés chacun sur une plaque, elles-mêmes montées parallèlement les unes aux autres sur des tiges.

L'émetteur est de préférence monté sur la plaque par des moyens offrant une faible conductivité thermique, par exemple inférieure à 30 W.m⁻¹.K⁻¹.

### BRÈVE DESCRIPTION DES DESSINS

La présente invention sera mieux comprise à l'aide de la description qui va suivre et des dessins sur lesquels :
- la figure 1 est une représentation schématique d'un exemple de réalisation d'un système thermophotovoltaïque,
- la figure 2 est une représentation schématique d'une variante du système de la figure 1, en vue de dessus et en vue de côté,
- les figures 3A à 3D sont des représentations schématiques d'autres exemples de réalisation d'émetteurs plans et d'un système thermophotovoltaïque en vue de dessus et en vue de côté,
- les figures 4A et 4B sont des représentations schématiques d'autres exemples de réalisation d'émetteurs semi-cylindriques et d'un système thermophotovoltaïque,
- les figures 5A et 5B sont des représentations schématiques d'autres exemples de réalisation d'émetteurs facettés et d'un système thermophotovoltaïque,
- les figures 6A et 6B sont des représentations schématiques d'autres exemples de réalisation d'émetteurs cylindriques et d'un système thermophotovoltaïque, en vue de dessus et en vue de côté,
- la figure 7A est une vue de côté d'une réalisation pratique d'un système thermophotovoltaïque,
- la figure 7B est une vue en coupe transversale le long du plan A-A du système de la figure 7A montrant l'émetteur vu du côté de la première surface,
- la figure 8 est une représentation schématique d'une variante d'un système thermophotovoltaïque dans lequel le concentrateur de flux solaire est formé par un collecteur réflecteur.

### EXPOSÉ DÉTAILLÉ DE MODES DE RÉALISATION PARTICULIERS

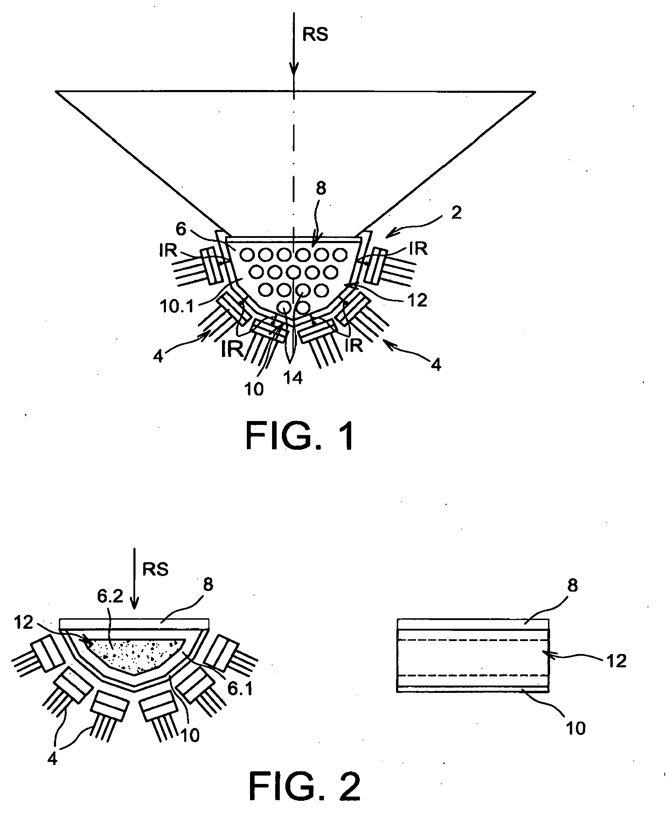

Sur la figure 1, on peut voir une représentation schématique d'un système thermophotovoltaïque comportant un émetteur 2 et une pluralité de cellules thermophotovoltaïques 4. Les cellules thermophotovoltaïques 4 sont composées de jonction de deux semi-conducteurs n et p. Les cellules peuvent être réalisées par exemple en Ge, GaSb, GaAsInSb. Leur gamme de longueur d'onde de conversion photovoltaïque est adaptée aux longueurs d'ondes infrarouges émises par l'émetteur. Par exemple, des cellules de GaSb convertiront par effet photovoltaïque les rayonnements infrarouges émis aux longueurs d'ondes inférieures à 1,7 micromètre.

La direction du rayonnement solaire concentré est prise comme direction longitudinale. Le rayonnement solaire est désigné RS.

L'émetteur 2 comporte un corps 6 délimité longitudinalement par une première surface extérieure 8 et une deuxième surface extérieure 10 et des surfaces latérales (non représentées). En outre, l'émetteur comporte au moins une chambre de combustion 12 réalisée dans le corps 6.

La première surface extérieure 8 est destinée à recevoir le rayonnement solaire RS de préférence concentré, par exemple au moyen de lentilles de Fresnel ou de réflecteur. Le rayonnement solaire est par exemple concentré 2000 fois.

La deuxième surface 10 est en regard des cellules thermophotovoltaïques 4. Dans l'exemple représenté, le corps a la forme d'un demi-cylindre d'axe X. La surface plane forme la première surface 8 et la surface incurvée forme la deuxième surface. En outre dans l'exemple représenté, la deuxième surface est formée de plusieurs faces planes 10.1 de sorte à être facettée. Le système peut comporter autant de cellules thermophotovoltaïques que de faces, pour optimiser la collecte du rayonnement infrarouge.

De préférence la deuxième surface extérieure 10 est plus grande que la première surface extérieure 8.

En effet, il est préférable de réduire la première surface extérieure pour limiter l'émission infrarouge par cette surface, émission qui ne pourra être convertie en électricité et d'augmenter la surface de la deuxième surface extérieure afin d'avoir une grande surface de cellules photovoltaïques.

Le rapport entre la deuxième surface extérieure 10 et la première surface extérieure 8 est alors de préférence compris entre 1 et 10, de manière encore préférée entre 1,5 et 4.

Dans l'exemple représenté, la chambre de combustion 12 est formée par une pluralité de canaux 14 s'étendant longitudinalement. Les canaux 14 sont alimentés en carburant gaz ou liquide et en oxygène, et sont connectés à une évacuation. Par exemple, le carburant peut être choisi parmi le H₂, les composés hydrocarbonés du type CₓH_{y}, en particulier le méthane, le propane, le butane et les biogas.

Les canaux 14 peuvent présenter des géométries complexes de sorte à confiner les gaz de combustion et augmenter le temps d'échange thermique avec l'émetteur. Par exemple, les canaux 14 peuvent comporter des portions allers et des portions retours au sein du corps, pour augmenter la distance parcourue par les gaz dans l'émetteur et ainsi favoriser l'échange de chaleur avec l'émetteur.

De manière avantageuse, l'émetteur peut comporter des circuits de canaux comprenant des canaux dans lesquels a lieu la combustion et des canaux dédiés à la recirculation des gaz chauds vers les canaux de combustion, pour maintenir la combustion et maximiser les transferts thermiques avec l'émetteur.

L'initiation de la combustion peut être provoquée par le chauffage des gaz, par exemple initiée par un arc électrique, ou par une réaction catalytique d'auto-inflammation, par exemple d'un mélange H₂/O₂. L'alimentation des gaz et leur évacuation sont préférentiellement faites par les faces latérales de l'émetteur par rapport à la direction du rayonnement solaire. Les moyens d'alimentation de la combustion et de moyens d'évacuation des gaz peuvent être formés par des canaux. Les canaux peuvent être de faibles dimensions, par exemple de quelques microns à quelques millimètres de diamètre dans le cas d'une microcombustion, ou alors de grandes dimensions de l'ordre du centimètre ou plus, dans le cas d'une combustion classique.

Un catalyseur de combustion peut être présent dans la chambre de combustion, par exemple sous la forme d'un dépôt sur la paroi intérieure des canaux, de façon à entretenir la combustion. Les catalyseurs peuvent par exemple être des platinoïdes (Pd-Pt-Rh) ou des pérovskites à base de lanthane.

L'alimentation et/ou l'évacuation de la chambre de combustion au niveau des extrémités latérales par rapport à la direction du rayonnement solaire permettent de ne pas réduire les première et deuxième surfaces destinées à recevoir le flux concentré et à émettre le rayonnement infrarouge respectivement.

Chaque cellule thermophotovoltaïque 4 est reliée électriquement à des moyens de collecte (non représentés) de l'électricité produite par conversion du rayonnement émis par l'émetteur.

Le flux solaire concentré permet de chauffer l'émetteur entre 500°C et 2500°C, typiquement entre 1000°C et 1500°C en fonction du rapport de concentration. On cherche à avoir une température de l'émetteur élevée pour avoir une émission infrarouge à suffisamment courte fréquence pour être efficacement convertie par la cellule.

Le matériau du corps de l'émetteur est choisi de telle sorte qu'il supporte ces températures de fonctionnement. Il est par exemple réalisé en un ou plusieurs matériaux réfractaires résistant à la gamme de températures mentionnée ci-dessus, par exemple il peut s'agir de carbure de silicium, tungstène, d'oxydes de terres rares, tels que le Er₂O₃, Yb₂O₃..., ou d'une combinaison de ces matériaux.

La première surface 8 pourra avantageusement être revêtue d'un matériau destiné à améliorer l'absorption du rayonnement solaire, par exemple par des revêtements à base de silicone comme les peintures Pyromark®, et la deuxième surface 10 pourra avantageusement être revêtue d'un matériau destiné à contrôler l'émission du rayonnement infrarouge, par exemple d'une couche en oxydes de terres rares.

Les première et deuxième surfaces pourront être texturées, de façon à modifier les paramètres d'absorption ou d'émission respectivement. Il est également envisageable d'ajuster les performances optiques en réalisant des structures spécifiques en surface permettant de découpler les comportements optiques dans les gammes visible et infrarouge. Dans le cas de la première surface extérieure, ces structures permettent d'absorber préférentiellement le rayonnement visible et de réfléchir le rayonnement infrarouge, de façon à diminuer l'émissivité de la première surface extérieure dans le rayonnement infrarouge.

En outre, de manière préférentielle le système est réalisé de sorte à limiter les déperditions thermiques et à maximiser la température de l'émetteur. Pour cela, on peut prévoir que les pièces en contact avec le corps de l'émetteur, par exemple formant support de celui-ci, présentent une faible conductivité thermique, de préférence inférieure à 10 W.m⁻¹.K⁻¹. Par exemple, le matériau peut être de la zircone, de l'alumine, un aérogel ou tout autre matériau offrant une faible conductivité thermique. Ceci permet de maximiser le rendement du système en abaissant la longueur d'onde caractéristique du rayonnement émis.

Des filtres de contrôle spectral peuvent être interposés entre la deuxième surface extérieure 10 et les cellules photovoltaïques. Les filtres de contrôle spectral peuvent être composés d'un système de multicouches déposées sur un substrat de verre ou sur les cellules.

Une enveloppe sous vide pourra entourer l'émetteur, de façon à limiter les pertes thermiques par convection de l'air. Celle-ci présentera au moins deux fenêtres transparentes aux rayonnements visibles et infrarouges du côté du rayonnement solaire concentré incident et du côté de l'émission du rayonnement infrarouge en direction des cellules thermophotovoltaïques. Elle comprendra aussi au moins deux passages de connections gaz pour l'arrivée et l'évacuation des gaz de combustion.

Le système comporte également des moyens de contrôle afin de gérer la combustion au sein de l'émetteur en fonction de l'intensité du rayonnement lumineux. La température de l'émetteur sera gérée, préférentiellement par une méthode sans contact comme la pyrométrie infrarouge. On peut également envisager d'utiliser un thermocouple haute température. Si la température décroit, la combustion interne pourra être déclenchée et les débits de gaz seront ajustés de façon à maintenir la température d'émetteur désirée. Les moyens de contrôle permettent alors de maintenir sensiblement constante la température de l'émetteur quelles que soient les conditions d'ensoleillement, et donc d'obtenir une production d'électricité sensiblement constante.

Nous allons maintenant expliquer le fonctionnement de ce système thermophotovoltaïque de production d'électricité.

Nous considérons tout d'abord le cas de conditions d'ensoleillement optimales. Dans ce cas, le système peut fonctionner uniquement avec le rayonnement solaire.

La première surface 8 reçoit le rayonnement solaire, qui a été préalablement concentré par les lentilles de Fresnel par exemple, ce rayonnement lumineux est absorbé par le corps de l'émetteur qui s'échauffe. Cet échauffement ce traduit par l'émission par la deuxième surface 10 d'un rayonnement électromagnétique dans l'infrarouge, les photons de ce rayonnement sont absorbés par les cellules 4 et créent des porteurs de charge électrique, ce qui génère de l'électricité.

Si l'ensoleillement est insuffisant par exemple du fait de la présence de nuage, les moyens de contrôle provoquent la combustion de gaz, par exemple de H₂ et O₂ dans la chambre de combustion 12, ce qui provoque un dégagement de chaleur, absorbée par le corps 6 de l'émetteur 2, compensant ainsi le faible rayonnement lumineux. Le rayonnement solaire chauffe le corps 6 de l'émetteur 2 par la première surface extérieure 8 et les gaz de combustion chauffent le corps,6 de l'émetteur 2 de l'intérieur.

En l'absence de rayonnement lumineux, par exemple en pleine nuit, le corps est chauffé uniquement au moyen de la réaction de combustion dans la chambre de combustion 12.

Il est alors possible de générer une quantité de courant constante tout au long de la journée et de l'année, quelles que soient les conditions d'ensoleillement.

L'émetteur selon l'invention est adapté à la fois à un fonctionnement en mode solaire seul et en mode combustion seul. L'émetteur comporte des zones pleines pour conduire la chaleur de la première surface à la deuxième surface et de la chambre de combustion à la deuxième surface. Pour cela, la distance et la conductivité thermique entre la première surface éclairée par le rayonnement solaire et la zone d'émission infrarouge sont choisies de sorte à assurer un très bon transfert de chaleur. La conductivité thermique du matériau formant l'émetteur est de préférence comprise 100 W.m⁻¹K⁻¹ entre 300 W.m⁻¹K⁻¹ ou est supérieure à 300 W.m⁻¹K⁻¹.

En outre, de manière avantageuse le rayonnement solaire concentré éclaire la première surface qui est située à l'opposé de la deuxième surface par rapport à la chambre de combustion, ainsi les cellules thermophotovoltaïques sont protégées du rayonnement solaire concentré. Le ou les matériau(x) et l'épaisseur de l'émetteur sont tels que le rayonnement solaire incident n'est pas, même en partie, transmis.

La disposition préférentielle dans laquelle les deux surfaces extérieures 8, 10 sont disposées de part et d'autre de la chambre de combustion 12 permet d'avoir un trajet thermique court à la fois entre la première surface 8 et la deuxième surface 10 et entre le chambre de combustion 12 et la deuxième surface 10. Ainsi le système offre un bon fonctionnement avec l'une ou l'autre ou les deux sources d'énergie.

Sur la figure 2, on peut voir une variante du système de la figure 1, dans laquelle le corps 6 de l'émetteur est composite, celui-ci comporte une enveloppe 6.1 en matériau non poreux et une âme 6.2 en matériau poreux, les pores de l'âme formant une multitude de chambres de combustion.

Les matériaux poreux sont par exemple du carbure de silicium ou une autre céramique haute température dont le procédé de fabrication permet d'obtenir une porosité ouverte. Le taux de porosité est fonction de la combustion désirée. Elle est préférentiellement comprise entre 50 % et 95 %.

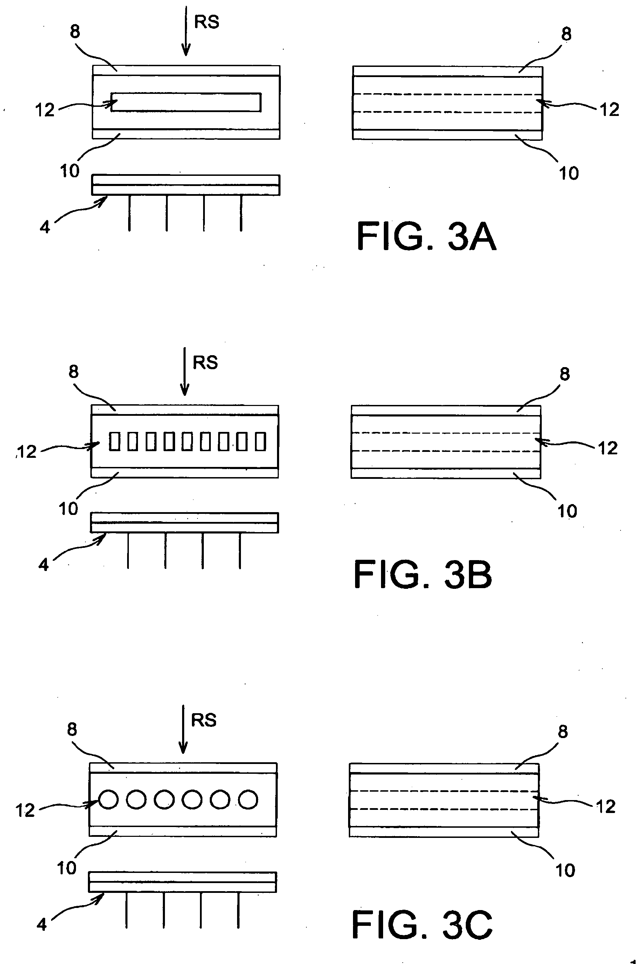

Sur les figures 3A à 3D, d'autres exemples de réalisation d'un système thermophotovoltaïque sont représentés. Dans ces exemples, l'émetteur présente la forme d'un parallélépipède rectangle dont une des grandes surfaces forme la première surface 8 et l'autre grande surface forme la deuxième surface 10. Une ou plusieurs cellules(s) thermophotovoltaïque(s) est ou sont disposée(s) en regard de la deuxième surface.

Les surfaces latérales non occupées par l'arrivée et la sortie des gaz seront préférentiellement isolées thermiquement, par exemple au moyen des couches comprenant un volume clos rempli d'air, de couches comprenant un volume clos tiré au vide et/ou de couches en matériau isolant comme l'alumine ou la zircone.

On peut prévoir de réaliser la structure à base d'un matériau présentant une conductivité thermique anisotrope et préférentiellement perpendiculaire au plan de l'émetteur. Ce matériau peut être une forêt de nanotubes de carbone dans une cavité par exemple de carbure de silicium. La porosité est alors constituée par les espaces entre les nanotubes de carbone.

Dans l'exemple de la figure 3A, la chambre de combustion 12 est formée par un seul canal de section rectangulaire dont la plus grande longueur s'étend perpendiculairement à la direction du rayonnement solaire RS, sur toute la longueur de l'émetteur, comme on peut le voir sur la vue de côté.

Dans les exemples des figures 3B et 3C, la chambre de combustion comporte plusieurs canaux s'étendant sur toute la longueur de l'émetteur, perpendiculairement à la direction du rayonnement solaire RS, et disposés les uns à côté des autres, sur la figure 3B les canaux ont une section rectangulaire, et sur la figure 3C, les canaux ont une section circulaire. On pourrait envisager d'avoir plusieurs rangées de canaux.

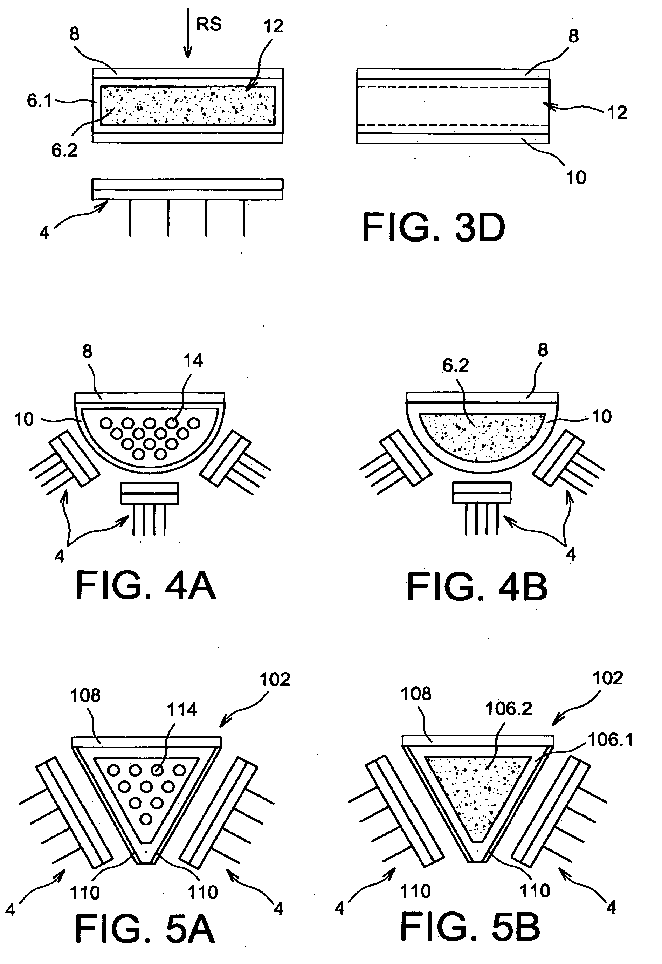

Sur la figure 3D, le corps 6 de l'émetteur est composite, celui-ci comporte une enveloppe 6.1 en matériau non poreux et une âme 6.2 en matériau poreux, formant la chambre de combustion.

Sur les figures 4A et 4B, on peut voir une variante du système de la figure 1, dans laquelle la deuxième surface n'est pas facettée. Dans l'exemple représenté, le nombre de cellules thermophotovoltaïques est réduit par rapport au système de la figure 1 mais celles-ci présentent des surfaces plus grandes. Le nombre et la taille des cellules ne sont en aucun cas limitatifs. Des cellules ayant une surface réceptrice concave sont également envisageables.

Sur la figure 4A, la chambre de combustion 12 est formée d'une pluralité de canaux 14 s'étendant sur toute la longueur, perpendiculairement à la direction du rayonnement solaire RS, et sur la figure 4B, l'émetteur comporte une âme en matériau poreux 6.2.

Sur les figures 5A et 5B, on peut voir un autre exemple de réalisation d'un système thermophotovoltaïque, dans lequel l'émetteur 102 comporte un corps en forme de prisme à section triangulaire.

La première surface 108 de l'émetteur est formée par l'une des faces du prisme. La deuxième surface 110 est formée par les deux autres faces du prisme. Une cellule thermophotovoltaïque 4 est disposée en regard de chacune des faces de la deuxième surface 110.

Sur la figure 5A, la chambre de combustion comporte des canaux 114 qui s'étendent entre les deux faces longitudinales. Les canaux sont répartis dans le corps. Dans l'exemple représenté, ils sont répartis de manière régulière.

Sur la figure 5B, l'émetteur comporte une enveloppe en matériau non poreux 106.1 et une âme en matériau poreux 106.2 ayant une forme prismatique correspondante.

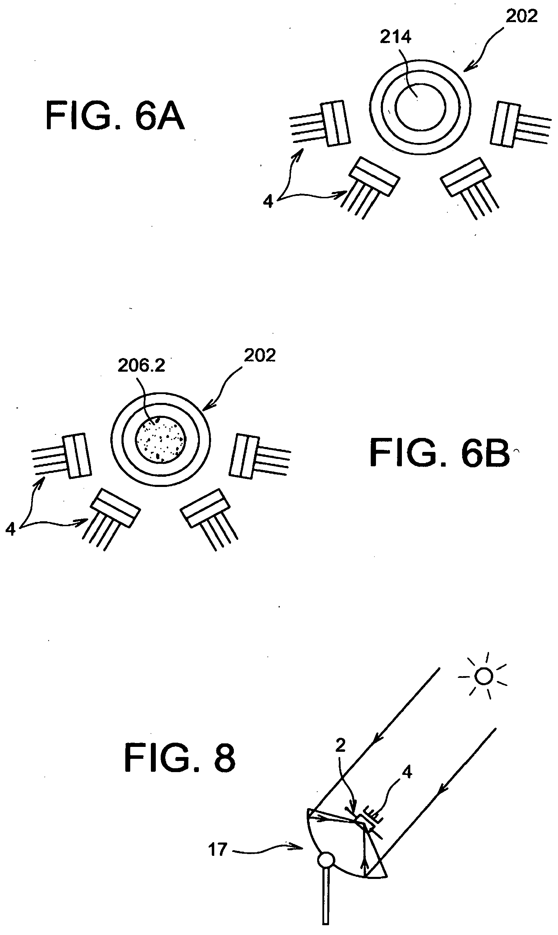

Sur les figures 6A et 6B, on peut voir un autre exemple de réalisation d'un système thermophotovoltaïque dans lequel l'émetteur 202 comporte un corps en forme de cylindre de révolution d'axe longitudinal X.

Sur la figure 6A, la chambre de combustion est formée d'un canal unique 214. Une chambre de combustion composée d'une pluralité de canaux parallèles ne sort pas du cadre de la présente invention. Sur la figure 6B, l'émetteur comporte une âme en matériau poreux.

Les exemples de réalisations représentés, sur les figures 3B, 3C, 3D sont particulièrement intéressants car ils présentent une conductivité thermique de la face réceptrice du rayonnement solaire vers la face émettrice de rayons infrarouges améliorée de par la présence de matériaux conducteurs entre les cellules de combustion. La température de la face émettrice est alors maximisée lors du fonctionnement en concentration solaire, et de fait la quantité d'énergie électrique produite. En outre, les configurations de ces systèmes permettent de limiter le nombre de cellules thermophotovoltaïques, voire de n'utiliser qu'une seule cellule, placées en face de la surface émettrice.

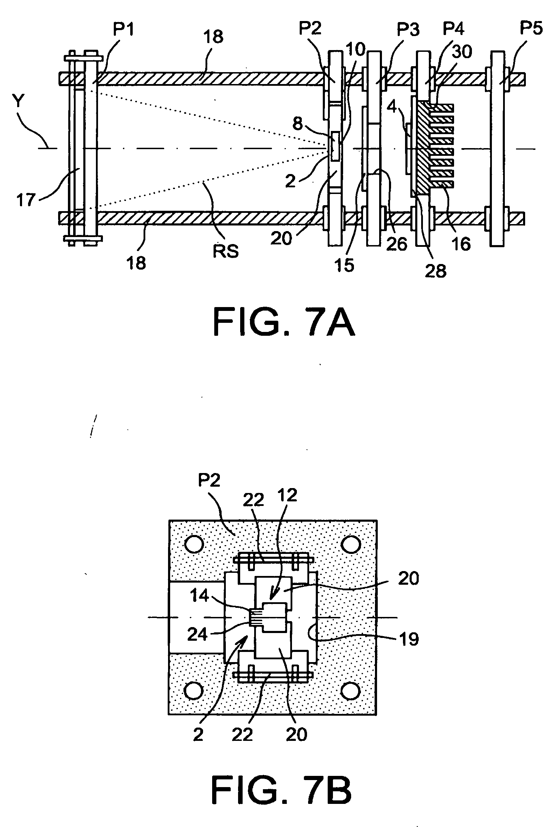

Sur la figure 7A, on peut voir un exemple de réalisation pratique d'un système thermophotovoltaïque hybride ou mixte vu de côté.

Le système présente un axe longitudinal Y. Le système comporte, de gauche à droite dans la représentation de la figure 7A, le concentrateur à lentille de Fresnel 17, l'émetteur 2, un filtre infrarouge 15, la cellule thermophotovoltaïque 4 associée à un radiateur 16.

Chacun des éléments énoncés est monté sur une plaque P1, P2, P3, P4, elle-même montée sur quatre tiges 18 traversant chaque plaque à ses quatre coins.

Sur la figure 7B, on peut voir une vue de l'émetteur du côté de la première face, monté dans une ouverture centrale 19 de la plaque P2.

L'émetteur est monté dans la plaque P2, au moyen de deux supports latéraux 20 entre lesquels le support est maintenu serré. Les deux supports 20 sont eux-mêmes fixés sur des pièces 22 montées sur la plaque P2. Les supports 20 sont avantageusement en deux parties, ce qui permet d'éviter une fixation rigide de l'émetteur sur l'un des supports et permet une certaine dilatation thermique entre l'émetteur et son support lors du chauffage à très haute température. En effet, dans l'exemple représenté, l'émetteur est inséré dans deux gorges réalisées dans les pièces support 20. En variante, on pourrait envisager de ne pas utiliser de support, l'émetteur pourrait alors être tenu par les éléments d'alimentation et d'échappement des cellules de combustion.

Comme cela a été décrit précédemment, le support 20 offre de préférence une faible conductivité thermique pour éviter les fuites latérales.

Sur cette figure 7B, on peut voir un système, les canaux 14 de la chambre de combustion et l'allumeur 24 représentés schématiquement.

La lentille de Fresnel 17 est fixée sur la plaque P1 par des moyens de serrage dans l'exemple représenté, la plaque P1 comporte une ouverture centrale pour le passage du flux solaire concentré.

Le filtre infrarouge 15 est monté sur la plaque P3 qui comporte également une ouverture centrale 26.

La cellule thermophotovoltaïque 4 est montée sur un support 28, avantageusement un support offrant une bonne conductivité thermique, par exemple en cuivre par lequel elle est montée sur la plaque P4. Le radiateur est monté sur le support 28 sur la face opposée à celle portant la cellule. Le radiateur 28 sert à évacuer la chaleur de la cellule, qui est conduite de la cellule au radiateur à travers le support en cuivre 28. La plaque P4 comporte également une ouverture centrale 30 pour le montage de l'ensemble, cellule, support et radiateur

Les plaques et les éléments qu'elles portent sont disposés les uns par rapport aux autres selon des distances données déterminées en fonction des caractéristiques de différents éléments afin d'optimiser le rendement du système. Par exemple, la distance entre la lentille de Fresnel et la première surface est égale à la distance focale de la lentille de Fresnel.

Des mesures de température peuvent être faites sur l'émetteur, sur le filtre infrarouge et sur le support de la cellule photovoltaïque pour le suivi du système. Les mesures sont effectuées par thermocouples ou pyromètre optique pour l'émetteur. D'autres moyens de mesure peuvent être utilisés.

Sur la figure 8, on peur voir une vue d'ensemble d'un système thermophotovoltaïque dans lequel le concentrateur 17 est formé par un réflecteur de forme parabolique monté en haut d'un mât.

Les rayons solaires sont collectés par le réflecteur qui les réfléchit sur la première surface de l'émetteur.

Nous allons maintenant décrire des exemples de procédés de réalisation des systèmes thermophotovoltaïques décrits ci-dessus.

Dans un exemple de procédé de réalisation, l'émetteur est réalisé dans une pièce massive comportant un ou plusieurs canaux. La pièce peut être réalisée par frittage de poudres céramiques. Les canaux sont alors obtenus soit par usinage de la pièce, soit par moulage. L'usinage peut être réalisé par des outils habituels ou avantageusement par laser, réduisant les risques d'initiation de fissures. L'usinage peut avoir lieu sur la pièce crue ou après frittage. Les surfaces externes peuvent être texturées pour améliorer les propriétés optiques, par exemple par gravure sèche ou humide de motifs avec un contre-masque en résine, comme un polymère, ou un matériau dur comme le SiO₂, la gravure a de préférence lieu sur la pièce frittée, ce qui permet d'obtenir une très bonne précision dimensionnelle.

Dans un autre exemple de procédé de réalisation, on réalise des demi-pièces dans lesquelles sont usinées des demi-canaux, puis celles-ci sont assemblées par scellement, brasage de type standard ou réactif ou assemblage par diffusion des deux pièces. L'usinage est par exemple du type mécanique, ou du type par gravure plasma ou du type par ablation laser. Ce procédé permet avantageusement d'obtenir des circuits de canaux complexes pouvant comprendre des parties dédiées à la combustion et une contre-circulation des gaz chauds pour limiter la déperdition par convection ou conduction et assurer des bonnes conditions de combustion, comme cela a été précédemment décrit. Par exemple les deux demi-pièces sont en SiC.

Les surfaces externes de l'émetteur peuvent être texturées pour améliorer les propriétés optiques, par exemple par gravure sèche ou humide de motifs de quelques micromètres avec un contre-masque en résine, comme un polymère, ou un matériau dur comme le SiO₂.

Dans les exemples où l'émetteur a une âme en matériau poreux, celle-ci est réalisée en céramique poreuse obtenue par exemple par frittage, puis celle-ci est introduite dans l'enveloppe externe en matériau non poreux. Les surfaces externes de l'enveloppe en matériau non poreux peuvent être texturées pour améliorer les propriétés optiques, par exemple par gravure sèche ou humide de motifs avec un contre-masque en résine, comme un polymère, ou un matériau dur comme le SiO₂.

Le système selon la présente invention est de réalisation relativement simple, il travaille à des températures comprise entre 900°C et 1500°C, qui réduit les contraintes thermomécaniques et améliore la fiabilité. En outre, à ces température de fonctionnement, des matériaux ne se dégradant pas sous air peuvent être utilisée, comme le carbure de silicium, et permet donc une simplification du système puisqu'il n'est pas nécessaire d'avoir le vide et un gain en durabilité.

En outre, ils peuvent présenter des taille réduite de système, par exemple 10×10×2 mm³. Une microcombution catalytique dans son volume peut être réalisée, ce qui limite la consommation de gaz. Cette taille réduite permet également juxtaposer des modules analogues à celui de la figure 7a sur un même système de suivi du soleil, par exemple en utilisant une concentration par lentilles de Fresnel.

Grâce à l'invention, il est possible de générer de l'électricité à partir de deux sources d'énergie complémentaires et combinées : l'énergie solaire par concentration du rayonnement solaire et l'énergie par combustion par exemple de biogaz ou hydrogène.

En outre, il est possible de produire de l'électricité thermophotovoltaïque le jour et la nuit. La production annuelle d'un tel système peut alors être largement augmentée par rapport aux systèmes existants puisque la production peut être permanente. Les problèmes de production intermittente d'électricité propres à la production à partir d'énergie solaire sont également réduits. L'invention permet alors de supprimer les moyens de stockage d'énergie électrique ou thermique pour compenser les variations d'ensoleillement, tels que les batteries, sels fondus (hautes températures), lits de roches (basses températures) qui sont généralement des moyens lourds.

Par ailleurs l'invention permet, grâce à la combustion, de compenser la faiblesse de production de la partie concentration solaire dans des conditions climatiques défavorables, comme par exemple une couverture nuageuse. La combustion offre également l'avantage de pouvoir maintenir la température de l'émetteur, donc la quantité d'énergie produite. L'invention permettra donc de maintenir la production par conditions de lumière diffuse.

En outre, l'invention offre une certaine souplesse de production d'électricité capable de s'adapter à des pics de demande en augmentant temporairement la température de l'émetteur par combustion au moment désiré. En effet, le rendement du système est directement dépendant de la température de l'émetteur et donc des flux de gaz de combustion.

Le contrôle de la combustion peut permettre avantageusement de piloter la température de l'émetteur de façon à travailler en mode stationnaire à température constante alors que l'apport de la partie concentration sera variable. Ceci diminue les variations thermiques imposées à l'émetteur, la durée de vie de celui-ci est alors augmentée.

D'un point de vue industriel et commercial, la production d'électricité continue permet de diminuer le temps d'amortissement de l'installation par rapport aux systèmes photovoltaïques ne fonctionnant que de jour et dans des conditions climatiques favorables.

En outre, l'émetteur selon l'invention combine les éléments de générateur solaire et des générateurs thermiques en mettant en commun une grande partie de éléments : émetteurs, filtres, cellules thermophotovoltaïques, traitement électrique, distribution, terrains.

Grâce à l'invention, puisque la production est largement indépendante des conditions climatiques, les systèmes thermophotovoltaïques mixtes ou hybrides peuvent être installés dans des pays offrant des conditions d'ensoleillement non-optimales.

Les systèmes thermophotovoltaïques mixtes ou hybrides selon l'invention sont particulièrement adaptés à la production d'électricité.

## Revendications

1. Système thermophotovoltaïque comportant un émetteur de rayonnement infrarouge (2, 102, 202) comportant un corps (6) muni d'une première surface extérieure (8, 108) et d'une deuxième surface extérieure (10, 110), lesdites première (8, 108) et deuxième (10, 110) surfaces extérieures étant distinctes, la première surface extérieure étant destinée à recevoir un rayonnement solaire concentré, la deuxième surface extérieure (10, 110) étant destinée à émettre un rayonnement infrarouge, ledit corps (6) comportant en son sein au moins une chambre de combustion (12) de gaz et/ou de liquide, dans lequel la chambre de combustion est alimentée à travers une surface extérieure de l'émetteur distincte de la première et de la deuxième surface extérieure, ledit système comportant également un concentrateur (17) disposé en face de la première surface extérieure (8, 108) de l'émetteur, des moyens d'allumage (24) pour provoquer la combustion dans l'émetteur (2) et au moins une cellule thermophotovoltaïque (4) disposée en face de la deuxième surface extérieure (10, 110) et destinée à recevoir le rayonnement infrarouge émis par la deuxième surface de l'émetteur.

2. Système thermophotovoltaïque selon la revendication 1, dans lequel la deuxième surface extérieure (10, 110) est opposée à la première surface extérieure (8, 108) par rapport à ladite au moins une chambre de combustion (12).

3. Système thermophotovoltaïque selon la revendication 1 ou 2, dans lequel le corps (6) comporte au moins un canal (14, 114, 214) formant la chambre de combustion (12).

4. Système thermophotovoltaïque selon la revendication 3, dans lequel ledit au moins un canal (14, 114, 214) s'étend sensiblement parallèle aux première (8, 108) et deuxième (10, 110) surfaces extérieures.

5. Système thermophotovoltaïque selon la revendication 1 ou 2, dans lequel le corps (2) comporte une âme en matériau poreux (6.2, 106.2, 206.2) formant la chambre de combustion et une enveloppe en matériau non poreux (6.1, 106.1, 206.1).

6. Système thermophotovoltaïque selon l'une des revendications 1 à 5, dans lequel le rapport entre la deuxième surface extérieure et la première surface extérieure est compris entre 1 et 10, avantageusement entre 1,5 et 4.

7. Système thermophotovoltaïque selon l'une des revendications 1 à 6, dans lequel le corps (6) présente une forme de parallélépipède rectangle, une grande face portant la première surface extérieure (8) et la deuxième grande face portant la deuxième surface extérieure (10), et dans lequel la chambre de combustion (12) s'étend parallèlement aux première (8) et deuxième (10) surfaces extérieures.

8. Système thermophotovoltaïque selon l'une des revendications 1 à 6, dans lequel le corps (6) présente une section en demi-cercle, et a la forme d'un demi-cylindre, la surface convexe formant la deuxième surface extérieure (10) et la surface plane formant la première surface extérieure (8), la chambre de combustion (12) s'étendant parallèlement aux première (8) et deuxième (10) surfaces extérieures.

9. Système thermophotovoltaïque selon la revendication 7 ou 8, dans lequel la chambre de combustion est apte à être connectée à une source de carburant et d'oxygène au niveau d'au moins une de ses extrémités longitudinales.

10. Système thermophotovoltaïque selon l'une des revendications 1 à 9, dans lequel la chambre de combustion comporte un réseau de canaux (14, 114, 214) de sorte à améliorer l'échange thermique entre les gaz de combustion et le corps de l'émetteur.

11. Système thermophotovoltaïque selon l'une des revendications 1 à 10, dans lequel la première surface extérieure (8, 108) comporte un dépôt d'un matériau et/ou présente une texturation apte à améliorer l'absorption du rayonnement solaire et à diminuer son émissivité en rayonnement infrarouge.

12. Système thermophotovoltaïque selon l'une des revendications 1 à 11, dans lequel la deuxième surface extérieure (10, 110) comporte un dépôt d'un matériau et/ou une texturation aptes à contrôler l'émission infrarouge en augmentant son intensité et en diminuant son émissivité aux hautes longueurs d'onde, par exemple supérieures à 1,7 µm.

13. Système thermophotovoltaïque selon l'une des revendications 1 à 12, dans lequel le corps (6) est formé d'un ou plusieurs matériaux réfractaires tels que le carbure de silicium, tungstène, et/ou les oxydes de terres rares, tels que le Er₂O₃, Yb₂O₃...

14. Système thermophotovoltaïque selon l'une des revendications 1 à 13, comportant des moyens de contrôle de la combustion en fonction du niveau de rayonnement solaire, lesdits moyens de contrôle commandant avantageusement la combustion de sorte à maintenir l'émetteur à une température sensiblement constante.

15. Système thermophotovoltaïque selon l'une des revendications 1 à 14, dans lequel le concentrateur (17), l'émetteur (2, 102, 202) et la cellule thermophotovoltaïque (4) sont montés chacun sur une plaque (P1, P2, P4), elles-mêmes montées parallèlement les unes aux autres sur des tiges (18).

16. Système thermophotovoltaïque selon la revendication 15, dans lequel l'émetteur (2) est monté sur la plaque (P2) par des moyens offrant une faible conductivité thermique, par exemple inférieure à 30 W.m⁻¹.K⁻¹.

## Patentansprüche

1. Thermophotovoltaik-System, umfassend einen Emitter für infrarote Strahlung (2, 102, 202), umfassend einen Körper (6), welcher eine erste Außenfläche (8, 108) und eine zweite Außenfläche (10, 110) aufweist, wobei die erste (8, 108) und zweite (10, 110) Außenfläche verschieden sind, wobei die erste Außenfläche dazu vorgesehen ist, eine konzentrierte Sonnenstrahlung zu empfangen, wobei die zweite Außenfläche (10, 110) dazu vorgesehen ist, eine infrarote Strahlung zu emittieren, wobei der Körper (6) in seinem Inneren wenigstens eine Brennkammer (12) für Gas oder/und Flüssigkeit umfasst, wobei die Brennkammer durch eine Außenfläche des von der ersten und der zweiten Außenfläche verschiedenen Emitters versorgt wird, wobei das System ferner einen Konzentrator (17), welcher gegenüber der ersten Außenfläche (8, 108) des Emitters angeordnet ist, Zündmittel (24) zum Hervorrufen der Verbrennung in dem Emitter (2) und wenigstens eine Thermophotovoltaik-Zelle (4) umfasst, welche gegenüber der zweiten Außenfläche (10, 110) angeordnet und dazu vorgesehen ist, die von der zweiten Fläche des Emitters emittierte infrarote Strahlung zu empfangen.

2. Thermophotovoltaik-System nach Anspruch 1, wobei die zweite Außenfläche (10, 110) der ersten Außenfläche (8, 108) bezüglich der wenigstens einen Brennkammer (12) gegenüberliegt.

3. Thermophotovoltaik-System nach Anspruch 1 oder 2, wobei der Körper (6) wenigstens einen Kanal (14, 114, 214) umfasst, welcher die Brennkammer (12) bildet.

4. Thermophotovoltaik-System nach Anspruch 3, wobei der wenigstens eine Kanal (14, 114, 214) sich im Wesentlichen parallel zu der ersten (8, 108) und zweiten (10, 110) Außenfläche erstreckt.

5. Thermophotovoltaik-System nach Anspruch 1 oder 2, wobei der Körper (2) einen Innenraum aus porösem Material (6.2, 106.2, 206.2), welcher die Brennkammer bildet, und eine Hülle aus nicht-porösem Material (6.1, 106.1, 206.1) umfasst.

6. Thermophotovoltaik-System nach einem der Ansprüche 1 bis 5, wobei das Verhältnis zwischen der zweiten Außenfläche und der ersten Außenfläche zwischen 1 und 10 liegt, vorzugsweise zwischen 1,5 und 4.

7. Thermophotovoltaik-System nach einem der Ansprüche 1 bis 6, wobei der Körper (6) eine Form eines rechtwinkligen Parallelepipeds aufweist, wobei eine große Fläche die erste Außenfläche (8) trägt und die zweite große Fläche die zweite Außenfläche (10) trägt, und wobei die Brennkammer (12) sich parallel zu der ersten (8) und zweiten (10) Außenfläche erstreckt.

8. Thermophotovoltaik-System nach einem der Ansprüche 1 bis 6, wobei der Körper (6) einen Halbkreis-Querschnitt aufweist und die Form eines Halbzylinders hat, wobei die konvexe Fläche die zweite Außenfläche (10) bildet und die ebene Fläche die erste Außenfläche (8) bildet, wobei die Brennkammer (12) sich parallel zu der ersten (8) und zweiten (10) Außenfläche erstreckt.

9. Thermophotovoltaik-System nach Anspruch 7 oder 8, wobei die Brennkammer in der Lage ist, mit einer Brennstoff- und Sauerstoffquelle auf dem Niveau von wenigstens einem seiner Längsenden verbunden zu werden.

10. Thermophotovoltaik-System nach einem der Ansprüche 1 bis 9, wobei die Brennkammer ein Netz von Kanälen (14, 114, 214) derart umfasst, dass der Wärmeaustausch zwischen dem Brenngas und dem Körper des Emitters verbessert wird.

11. Thermophotovoltaik-System nach einem der Ansprüche 1 bis 10, wobei die erste Außenfläche (8, 108) eine Anlagerung eines Materials umfasst oder/und eine Texturierung aufweist, welche in der Lage ist, die Absorption der Sonnenstrahlung zu verbessern und ihr Emissionsvermögen an infraroter Strahlung zu verringern.

12. Thermophotovoltaik-System nach einem der Ansprüche 1 bis 11, wobei die zweite Außenfläche (10, 110) eine Anlagerung eines Materials oder/und eine Texturierung umfasst, welche in der Lage ist, die infrarote Emission zu steuern, indem bei großen Wellenlängen ihre Intensität erhöht wird und ihr Emissionsvermögen verringert wird, beispielsweise bei mehr als 1,7 µm.

13. Thermophotovoltaik-System nach einem der Ansprüche 1 bis 12, wobei der Körper (6) aus einem oder mehreren reflektierenden Materialien gebildet ist, wie beispielsweise Siliziumkarbid, Wolfram oder/und Oxiden von seltenen Erden, wie beispielsweise Er₂O₃, Yb₂O₃.

14. Thermophotovoltaik-System nach einem der Ansprüche 1 bis 13, umfassend Mittel zum Steuern der Verbrennung abhängig von dem Niveau der Sonnenstrahlung, wobei die Mittel zum Steuern vorzugsweise die Verbrennung derart kontrollieren, dass der Emitter bei einer im Wesentlichen konstanten Temperatur gehalten wird.

15. Thermophotovoltaik-System nach einem der Ansprüche 1 bis 14, wobei der Konzentrator (17), der Emitter (2, 102, 202) und die Thermophotovoltaik-Zelle (4) jeweils an einem Schild (P1, P2, P4) befestigt sind, welche wiederum zueinander parallel an Trägern (18) befestigt sind.

16. Thermophotovoltaik-System nach Anspruch 15, wobei der Emitter (2) an dem Schild (P2) durch Mittel befestigt ist, welche eine schwache thermische Leitfähigkeit aufweisen, beispielsweise kleiner als 30W.m⁻¹.K⁻¹.

## Claims

1. A thermo-photovoltaic system comprising an infrared radiation emitter (2, 102, 202) for a thermo-photovoltaic system comprising a body (6) provided with a first external surface (8, 108) and a second external surface (10, 110), said first (8, 108) and second (10, 110) external surfaces being distinct, the first external surface being arranged for receiving a concentrated solar radiation, the second external surface (10, 110) being arranged for emitting infrared radiation towards at least one thermo-photovoltaic cell (4), said body (6) comprising at least one gas and/or liquid combustion chamber (12) therein, wherein the combustion chamber is fed through an external surface of the emitter, which surface is distinct from the first and second external surfaces, said system also comprising a concentrator (17) provided in front of the first external surface (8, 108) of the emitter, ignition means (24) for causing the combustion in the emitter (2) and at least one thermo-photovoltaic cell (4) provided in front of the second external surface (10, 110) and arranged for receiving the infrared radiation emitted by the second external surface of the emitter.

2. The thermo-photovoltaic system according to claim 1, wherein the second external surface (10, 110) is opposite the first external surface (8, 108) relative to said at least one combustion chamber (12).

3. The thermo-photovoltaic system according to claim 1 or 2, wherein the body (6) comprises at least one channel (14, 114, 214) forming the combustion chamber (12).

4. The thermo-photovoltaic system according to claim 3, wherein said at least one channel (14, 114, 214) extends substantially parallel to the first (8, 108) and second (10, 110) external surfaces.

5. The thermo-photovoltaic system according to claim 1 or 2, wherein the body (2) comprises a core of porous material (6.2, 106.2, 206.2) forming the combustion chamber and a shell of non-porous material (6.1, 106.1, 206.1).

6. The thermo-photovoltaic system according to one of claims 1 to 5, wherein the ratio of the second external surface area to the first external surface area is between 1 and 10, advantageously between 1.5 and 4.

7. The thermo-photovoltaic system according to one of claims 1 to 6, wherein the body (6) has a rectangular parallelepiped shape, a major face bearing the first external surface (8) and the second major face bearing the second external surface (10), and wherein the combustion chamber (12) extends parallel to the first (8) and second (10) external surfaces.

8. The thermo-photovoltaic system according to one of claims 1 to 6, wherein the body (6) has a semi-circle cross-section, and has a semi-cylindrical shape, the convex surface forming the second external surface (10) and the planar surface forming the first external surface (8), the combustion chamber (12) extending parallel to the first (8) and second (10) external surfaces.

9. The thermo-photovoltaic system according to claim 7 or 8, wherein the combustion chamber is able to be connected to a fuel and oxygen source at least at one longitudinal end thereof.

10. The thermo-photovoltaic system according to one of claims 1 to 9, wherein the combustion chamber comprises an array of channels (14, 114, 214) so as to improve heat exchange between combustion gases and the emitter body.

11. The thermo-photovoltaic system according to one of claims 1 to 10, wherein the first external surface (8, 108) comprises a deposit of a material and/or has a texturing able to improve solar radiation absorption and to decrease its infrared radiation emissivity.

12. The thermo-photovoltaic system according to one of claims 1 to 11, wherein the second external surface (10, 110) comprises a deposit of a material and/or a texturing able to control the infrared emission by increasing its intensity and by decreasing its emissivity at long wavelengths, for example higher than 1.7 µm.

13. The thermo-photovoltaic system according to one of claims 1 to 12, wherein the body (6) is formed with one or more refractory materials such as silicon carbide, tungsten and/or oxides of rare earths, such as Er₂O₃, Yb₂O₃.

14. The thermo-photovoltaic system according to one of claims 1 to 13, comprising combustion control means as a function of the solar radiation level, said control means advantageously controlling combustion so as to keep the emitter at a substantially constant temperature.

15. The thermo-photovoltaic system according to one of claims 1 to 14, wherein the concentrator (17), the emitter (2, 102, 202) and the thermo-photovoltaic cell (4) are each mounted to a plate (P1, P2, P4), in turn mounted parallel to each other on rods (18).

16. The thermo-photovoltaic system according to claim 15, wherein the emitter (2) is mounted to the plate (P2) by means exhibiting a low thermal conductivity, for example, lower than 30 W.m⁻¹.K⁻¹.
